Europäisches Patentamt

European Patent Office

Office européen des brevets

(11) Numéro de publication: **0 213 022 B1**

(12) **FASCICULE DE BREVET EUROPEEN**

(45) Date de publication de fascicule du brevet:
**25.09.91**

(21) Numéro de dépôt: **86401666.2**

(22) Date de dépôt: **25.07.86**

(51) Int. Cl.⁵: **H03M 11/00, B41J 5/10** ·

(54) **Clavier électronique actionnable d'une seule main.**

(30) Priorité: **29.07.85 FR 8511532**

(43) Date de publication de la demande:
**04.03.87 Bulletin 87/10**

(45) Mention de la délivrance du brevet:
**25.09.91 Bulletin 91/39**

(84) Etats contractants désignés:
**AT BE CH DE FR GB IT LI LU NL SE**

(56) Documents cités:

**EP-A- 0 002 247**      **DE-A- 1 561 223**
**DE-A- 2 020 487**      **FR-A- 2 360 427**
**FR-A- 2 418 493**      **GB-A- 2 071 578**
**GB-A- 2 076 743**      **US-A- 3 022 878**
**US-A- 4 042 777**

**XEROX DISCLOSURE JOURNAL, vol. 1, no. 2,
févier 1976, page 85, Stamford, Conn., US;
D.C. KOWALSKI: "Semi-captive keyboard"**

(73) Titulaire: **Guyot-Sionnest, Laurent
82 rue du Général Leclerc
F-92270 Bois-Colombes(FR)**

(72) Inventeur: **Guyot-Sionnest, Laurent
82 rue du Général Leclerc
F-92270 Bois-Colombes(FR)**

(74) Mandataire: **Bouju, André
Cabinet André Bouju B.P. 6250
F-75818 Paris Cédex 17(FR)**

Rank Xerox (UK) Business Services

## Description

La présente invention concerne un clavier électronique actionnable d'une seule main, notamment pour générer des caractères alphanumériques et analogues et/ou des instructions de traitement.

Les dispositifs de création de caractères alphanumériques les plus utilisés actuellement (claviers de terminaux d'ordinateurs ou de machines à écrire) sont une simple transposition électrique ou électronique des claviers mécaniques de la fin du XIXème siècle. Ces premiers claviers mécaniques sont caractérisés par le fait que l'action sur chaque touche ne peut créer au plus que deux signes différents. Il faut donc un grand nombre de touches, soixante au moins, pour générer l'ensemble des signes utilisés pour les messages écrits.

Du fait du grand nombre de touches il est nécessaire, avec ces claviers que le créateur des signes déplace sa ou ses mains sur une surface importante. Ces déplacements se traduisent par deux conséquences négatives:

La première conséquence est qu'une partie importante du temps de création des signes est affectée au simple déplacement des mains, en dehors de toute production réelle de signes.

La seconde conséquence est que l'opérateur est soit obligé de regarder le clavier pour viser et agir sur la touche correcte, ce qui l'empêche de garder les yeux sur le modèle qu'il veut transcrire et/ou de contrôler le résultat produit ou de s'abstraire mentalement pour se concentrer sur le message à créer, soit obligé d'acquérir par formation et entraînement long (plusieurs dizaines d'heures) une dexterité suffisante pour ne pas regarder le clavier tout en produisant un message sans erreur.

Outre ces inconvénients fonctionnels, les claviers classiques sont encombrants (plus de trois cents cm2 pour un clavier permettant la frappe avec les dix doigts), lourds et coûteux puisqu'il faut fabriquer au moins soixante dispositifs électro-mécaniques élémentaires. Enfin l'usage de ces claviers nécessite une position assise assez rigide et assez précise, ce qui est une contrainte en comparaison avec l'écriture manuscrite et ce qui entraîne une fatigue importante chez tous les utilisateurs non-spécialisés.

Les résultats pratiques sont que l'usage professionnel de ce type de clavier a été limité à une population de personnes spécialisées et que la vitesse d'écriture au clavier des autres utilisateurs éventuels reste bien souvent deux à cinq fois plus faible que la vitesse habituelle d'écriture avec une plume ou un crayon.

Avec l'arrivée de l'électronique et des ordinateurs, les fabriquants ont ajouté des possibilités de démultiplication du nombre de signes produits par chaque touche. Cela a été obtenu par l'adjonction de touches de conversion et de tables électroniques exploitées par microprocesseur qui permettent de générer trois ou quatre signes différents avec la même touche. Cette démultiplication permet de générer jusqu'à deux cent cinquante six signes différents (ceux du code ASCII étendu par exemple). Cette démultiplication est néanmoins limitée par le fait que l'on ne peut aller au delà de quatres signes différents dessinés sur la touche si l'on veut que l'opérateur non entraîné retrouve suffisamment vite la touche qu'il doit utiliser. De plus, ces touches de conversion sont en un seul exemplaire ce qui casse, pour la moitié des touches, la bonne habitude et l'entraînement d'actionner une touche avec un doigt donné d'une main donnée.

Pour les claviers de terminaux d'ordinateurs, les constructeurs ont été amenés à ajouter des touches dites de fonction, dix au minimum et bien souvent vingt-quatre ou trente-six. L'inconvénient de ces touches de fonction réside dans le fait que pratiquement personne n'est en mesure de les actionner sans regarder où elles sont et sans avoir à regarder comment revenir à la position normale de frappe. Cet inconvénient a été suffisamment important pour susciter l'apparition de dispositifs tels que "Souris", écrans tactiles, commandes par icones et cetera.

Tout ceci fait que, avec les claviers électroniques, même les personnes spécialisées subissent les inconvénients de la conception de claviers à plus de soixante touches.

Un certain nombre de dispositifs ont été décrits pour réduire les inconvénients des claviers classiques. Certains ont visé l'augmentation de la vitesse de frappe afin de se rapprocher de la vitesse de la parole (plus de 100 mots/minute). D'autres ont surtout cherché à rendre plus facile la création de signes codés par les utilisateurs non-spécialisés.

Dans ce cas les solutions ont souvent visé à permettre le travail d'une seule main, positionnée de façon fixe, grâce à la seule action combinée des doigts sur un nombre limité de touches. Ce faisant les inventeurs ont cherché à diminuer le temps d'acquisition d'une adresse suffisante. De façon complémentaire, et par opposition aux positions arbitraires des touches sur un clavier classique, ces inventeurs ont cherché à ce que l'action nécessaire à la génération d'un signal donné puisse être rapidement apprise. Ces nouveaux systèmes ne réussissent pas à se développer pour plusieurs raisons.

La première réside dans le fait qu'avec cinq touches ordinaires le nombre de signes différents que l'on peut générer de façon aisée est trop faible par rapport aux besoins des messages écrits. Cinq touches ordinaires permettent en effet de générer directement $(2 \times 2 \times 2 \times 2 \times 2 - 1)$ soit trente et un signes alors que les messages écrits utilisent plus de cent signes différents et ont besoin d'une bonne dizaine de commandes de présentation. A ces besoins s'ajoutent ceux des "commandes" à adresser à la machine utilisée.

La seconde raison réside dans le fait que la mémorisation des combinaisons nécessite un effort important d'apprentissage. Cet inévitable effort d'apprentissage paraît notamment important du fait que la limitation des oodes possibles rend certaines combinaisons très peu logiques, et rebutantes pour l'utilisateur potentiel. De plus les produits offerts n'évitent pas à une personne l'obligation d'avoir à apprendre et à se servir des claviers classiques, qui restent les seuls offerts sur la majorité des terminaux présents sur les sites professionels. Enfin ces dispositifs présentent peu d'intérêt pour des personnes déjà entraînées aux claviers classiques.

Parmi les claviers connus du genre précité, on peut citer ceux décrits par les brevets américains 3 022 878 et 4 042 777 et par les demandes de brevet français 2 360 427 et 2 418 493. Ceux-ci présentent en particulier des inconvénients liés à une combinatoire trop riche ou trop pauvre, un apprentissage long et relativement difficile, une utilisation parfois assez compliquée pour un opérateur non spécialisé et un caractère d universalité non démontré.

En particulier, les claviers combinatoires dans lesquels chaque doigt peut appuyer simultanément sur plusieurs touches adjacentes (US-A-4 042 777 et EP-A-002 247) présentent l'inconvénient de nécessiter une grande adresse car les contacts distincts sont très proches et supposent des déplacements de doigts dans plusieurs directions, de ne pas à inciter à travailler sans les regarder car les signes sont gravés sur les touches, de ne pas être universels, d'être d'encombrement supérieur à ce qui est admissible dans une poche ou sur un poignet et de ne pas être utilisables indifféremment d'une main ou de l'autre. Le clavier décrit par le FR-A-2 418 493 est pénalisé par une combinatoire trop pauvre et par l'utilisation du petit doigt peu habile, présente l'inconvénient de ne pas pouvoir être utilisé indifféremment par la main droite ou la main gauche, de ne pas avoir de mnémotechnique simple et de ne pas avoir de système de correction lorsqu'on a actionné une touche par erreur, maladresse ou tâtonnement. Enfin, ceux décrits par les US-A-3 022 878 et 3 428 747 ont une combinatoire trop riche rendant les mnémotechniques irréalistes, utilisent des touches complexes non adaptées au travail sans regarder et n'ont pas de système de correction lorsqu'on a actionné une touche par erreur, maladresse ou tâtonnement.

On connaît selon l'US-A-4 042 777 un clavier électronique actionnable d'une seule main, notamment pour générer des caractères alphanumériques et analogues et/ou des instructions de traitement, ce clavier comprenant plusieurs touches et un circuit électronique relié électriquement à ces touches pour interpréter l'état des touches et délivrer un signal indicatif de celui-ci. Ce circuit électronique est également relié à des moyens de visualisation ainsi qu'à des moyens de raccordement extérieur. Le clavier comprend au moins deux touches affectées aux doigts d'une main autres que le pouce et une touche affectée au pouce, chaque touche affectée à un doigt de la main autre que le pouce pouvant prendre trois états distincts sous l'action dudit doigt et comprenant deux parties s'étendant suivant le prolongement de ce doigt, de sorte que chacune des deux parties puisse être actionnée par le doigt correspondant en même temps que d'autres parties de touches voisines par d'autres doigts, sans déplacement sensible de la main. La touche affectée au pouce peut prendre cinq états distincts sous l'action du pouce, cette touche comprenant quatre parties qui sont disposées de manière à pouvoir être actionnées sélectivement par le pouce, sans déplacement sensible de la main et en même temps qu'une partie de chaque touche affectée aux doigts autres que le pouce.

Toutefois, il est prévu que l'utilisateur puisse actionner simultanément deux ou même quatre touches adjacentes de façon à obtenir un grand nombre de signaux avec un nombre réduit de touches. Cependant l'utilisation de ce clavier nécessite un apprentissage très long et oblige l'utilisateur à surveiller constamment la position de ses doigts pour éviter les erreurs.

Un clavier à touches du genre précité est également connu selon le DE-A-20 20 487.

Le FR-A1-2 418 493 divulgue un clavier comprenant plusieurs touches, un circuit électronique relié électriquement à des touches ainsi qu'à des moyens de visualisation en combinaison au sens de la présente demande de brevet, ledit circuit électronique comprenant dans un mode particulier de réalisation un microprocesseur.

Le but de l'invention est ainsi de proposer un clavier électronique actionnable d'une seule main par un utilisateur non expert, que l'on puisse utiliser sans le regarder, qui soit fiable c'est-à-dire avec lequel les risques d'erreurs de frappe sont pratiquement nuls, d'encombrement réduit, de puissance suffisante c'est-à-dire pouvant générer l'ensemble des caractères alphanumériques et instructions de traitement nécessaire dans les cas d'utilisation les plus courants, polyvalent, c'est-à-dire pouvant être relié à des ordinateurs, imprimantes diverses, appareils téléphoniques et dispositifs de commande par clavier de tout type, facilement adaptable à tout langage et toute technique, de compréhension, d'apprentissage et d'utilisation aisés.

Suivant l'invention, le clavier électronique est caractérisé en ce que des moyens sont prévus pour éviter tout actionnement simultané des différentes parties d'une même touche et/ou toute modification simultanée de l'état des contacts électriques associés à cette touche, et en ce que le circuit électronique est adapté à ne prendre en compte, pour chaque touche, lorsque toutes les parties de cette touche sont relâchées, que la modification de l'état d'un contact qui est intervenue la première.

Chaque touche étant affectée à un doigt déterminé, on évite ainsi les risques d'erreurs de frappe qui peuvent se produire lorsque la génération d'un signal donné nécessite l'actionnement simultané de deux touches par un même doigt. En outre, les touches étant disposées de manière à pouvoir être actionnées simultanément par les doigts d'une main sans déplacement sensible de celle-ci, l'utilisation du clavier est peu fatigante et pratique. Enfin, les trois états distincts des touches destinées aux doigts autres que le pouce et les cinq états distincts de la touche destinée au pouce procurent une combinatoire suffisamment riche tout en restant simple puisque par exemple avec trois touches "doigt sauf pouce" et la touche "pouce", on peut générer directement jusqu'à (3X3X3X5)-1 soit cent trente quatre signes ou instructions différents.

De préférence, les deux parties de chaque touche destinée à être actionnée par un doigt autre que le pouce, sont suffisamment proches l'une de l'autre pour pouvoir être actionnées successivement par un mouvement d'avant vers l'arrière et vice-versa de l'extrémité du doigt et les quatre parties de la touche destinée à être actionnée par le pouce comprennent une première paire disposée symétriquement de part et d'autre d'un axe sur lequel est disposée l'autre paire, ces parties étant suffisamment proches l'une de l'autre pour pouvoir être actionnées successivement par un mouvement d'avant vers l'arrière et vice versa de l'extrémité du pouce pour l'une des paires et par un mouvement de l'intérieur vers l'extérieur de la main et vice-versa de l'extrémité du pouce pour l'autre paire.

En mettant à profit les mouvements naturels et donc aisés des doigts d'une main, on renforce ainsi l'efficacité d'utilisation du clavier.

Par ailleurs, le profil des touches étant adapté à la forme des doigts et à la nature de leurs déplacements préférentiels cette efficacité est atteinte plus facilement.

Suivant une forme de réalisation avantageuse de l'invention, les deux parties des touches destinées à être actionnées par des doigts autres que le pouce, présentent chacune un profil incurvé vers l'intérieur de la touche correspondante, incliné vers le haut du centre de cette touche vers l'extérieur de chaque partie suivant la direction de déplacement des doigts et tactilement perceptible, tandis qu'une action sur chacune des parties provoque une modification de l'état d'un contact électrique à laquelle est sensible ledit circuit électronique, les quatres parties de la touche destinée à être actionnée par le pouce, présentent chacune un profil incurvé vers l'intérieur de la touche, incliné vers le haut du centre de cette touche vers l'extérieur de chaque partie suivant les directions préférentielles de déplacement du pouce et tactilement perceptible tandis qu'une action sur chacune de ces parties provoque une modification de l'état d'un contact électrique à laquelle est sensible ledit circuit électronique, et des moyens sont prévus pour éviter tout actionnement simultané des différentes parties d'une même touche et/ou toute modification simultanée de l'état des contacts électriques associés à cette touche, le circuit électronique étant adapté à ne prendre en compte, pour chaque touche et lorsque toutes les parties de cette touche sont relachées, que la modification de l'état d'un contact qui est intervenue la première.

Le profil de chacune des touches procure ainsi un obstacle au déplacement du doigt concerné vers la position visée. Ressentant tactilement cet obstacle, l'utilisateur est renseigné sans ambiguité sur la position de son doigt. Très rapidement, grâce à la grande capacité de mémorisation tactile des humains, l'utilisateur retient, dans sa main, chaque combinaison de positions des doigts. Par ailleurs, l'actionnement de chaque partie d'une même touche est volontairement rendu exclusif de sorte qu'en combinaison avec la reconnaissance tactile, les erreurs de frappe sont évitées, mêmes lors des manipulations rapides. Cela permet également de maintenir très proches les différentes parties de chaque touche et par conséquent de réaliser des touches de petite taille de sorte que les mouvements des doigts sont limités au minimum. Tandis que l'efficacité du clavier est accrue, ses dimensions peuvent être réduites.

D'autres particularités et avantages de l'invention résulteront encore de la description qui va suivre.

Aux dessins annexés donnés à titre d'exemples non limitatifs :
- la figure 1 est une vue en plan schématique d'un clavier conforme à l'invention,
- la figure 2 est une vue de profil agrandie suivant la flèche F de la figure 1 d'une touche destinée aux doigts autres que le pouce,
- la figure 3 est une vue identique à la précédente d'une touche destinée aux doigts autres que le pouce suivant une variante de réalisation,
- la figure 4 est une vue en plan agrandie de la touche destinée au pouce,

- la figure 5 et une vue de profil agrandie de la touche destinée au pouce suivant la flêche F' de la figure 4,
- la figure 6 est une vue de profil agrandie de la touche destinée au pouce suivant la flèche F'' de la figure 4,
- la figure 7 est une vue schématique en plan éclatée du clavier de la figure 1 illustrant le circuit électronique de ce clavier,
- les figures 8 à 14 sont des vues schématiques de claviers suivant des variantes de réalisation de l'invention, et,
- les figures 15 et 16 illustrent la table basique de transcodage conforme à l'invention.

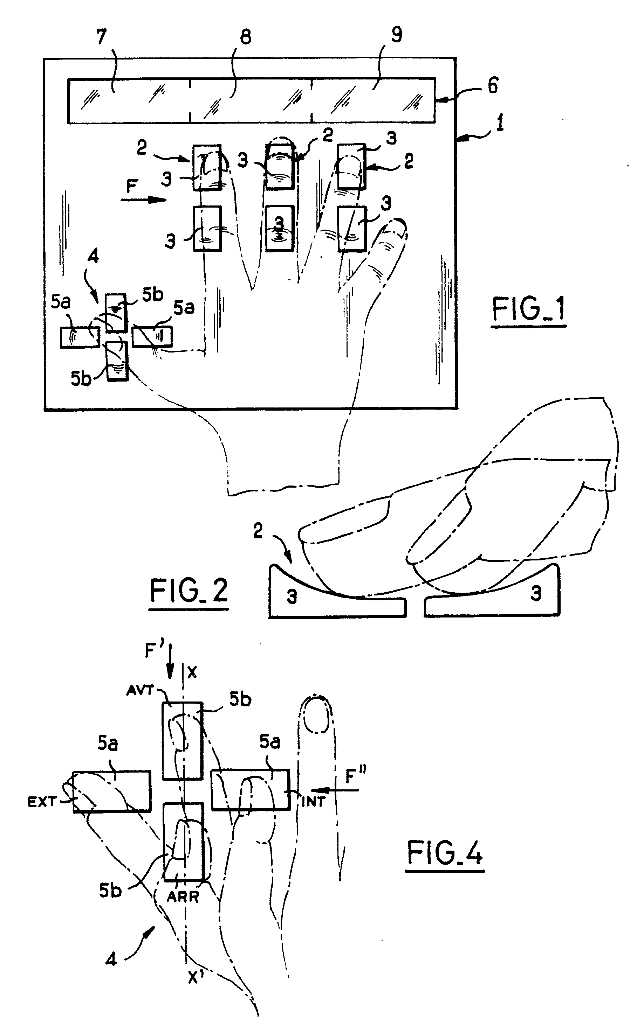

Les figures 1 à 7 illustrent une forme de réalisation préférentielle d'un clavier électronique 1 actionnable d'une seule main pour générer des caractères alphanumériques et analogues et/ou des instructions de traitement. Ce clavier 1 comprend plusieurs touches 2, 4 et un circuit électronique 10 relié électriquement de manière classique à ces touches 2, 4, par exemple par l'intermédiaire d'un circuit imprimé (non représenté), pour interpréter l'état des touches 2, 4 et délivrer un signal indicatif de celui-ci d'une manière qui sera détaillée plus loin. Le circuit électronique 10 est également relié à des moyens de visualisation 6 comprenant par exemple un écran du type à affichage digital ou à cristaux liquides comportant trois régions de visualisation 7, 8, 9 dont la fonction sera également explicitée plus loin, ainsi qu'à des moyens de raccordement extérieur 12 qui permettent de relier, par exemple électriquement, le clavier 1 à un dispositif à commande par clavier, par exemple, une imprimante ou un ordinateur (non représenté).

Dans l'exemple illustré, le clavier 1 comprend trois touches 2 affectées aux doigts d'une main autes que le pouce et une touche 4 affectée au pouce chaque touche 2 affectée à un doigt de la main autre que le pouce pouvant prendre trois états distincts sous l'action dudit doigt et comprenant deux parties 3 s'étendant suivant le prolongement de ce doigt, de sorte que chacune des deux parties 3 puisse être actionnée par le doigt correspondant en même temps que d'autres parties 3 de touches 2 voisines par d'autres doigts, sans déplacement sensible de la main. Par ailleurs, la touche 4 affectée au pouce peut prendre cinq états distincts sous l'action du pouce, cette touche comprenant quatre parties 5a, 5b qui sont disposées de manière à pouvoir être actionnées sélectivement par le pouce, sans déplacement sensible de la main et en même temps qu'une partie 3 de chaque touche 2 affectée aux doigts autres que le pouce.

De manière avantageuse (figs. 2 à 6), les deux parties 3 de chaque touche 2 destinée à être actionnée par un doigt autre que le pouce, sont suffisamment proches l'une de l'autre pour pouvoir être actionnées successivement par un mouvement d'avant vers l'arrière et vice-versa de l'extrémité du doigt et les quatre parties 5a, 5b de la touche 4 destinée à être actionnée par le pouce comprennent une première paire 5a disposée symétriquement de part et d'au tre d'un axe X-X' sur lequel est dipsosée l'autre paire 5b, ces parties étant suffisamment proches l'une de l'autre pour pouvoir être actionnées successivement par un mouvement d'avant vers l'arrière et vice-versa de l'extrémité du pouce pour l'une 5b des paires et par un mouvement de l'intérieur vers l'extérieur de la main et vice-versa de l'extrémité du pouce pour l'autre paire 5a.

Les trois états distincts pris par chacune des touches 2 destinées aux doigts autres.que le pouce sont ainsi :

- première partie ou deuxième partie 3 actionnée (états 1 et 2)
- première et deuxième partie 3 non actionnées ou relachées (état 3), tandis que les cinq états distincts pris par la touche 4 destinée au pouce sont :
- première ou deuxième ou troisième ou quatrième partie 5a ou 5b actionnée (états 1 à 4)
- première et deuxième et troisième et quatrième partie 5a et 5b non actionnées ou relachées(état 5).

On notera que l'invention s'appliquant aussi bien à un clavier du type sensitif qu'à un clavier du type électro-mécanique, une action sur une touche sensitive correspond à un simple toucher de cette touche par un doigt tandis qu'une action sur une touche électromécanique correspond à un enfoncement par un doigt de cette touche.

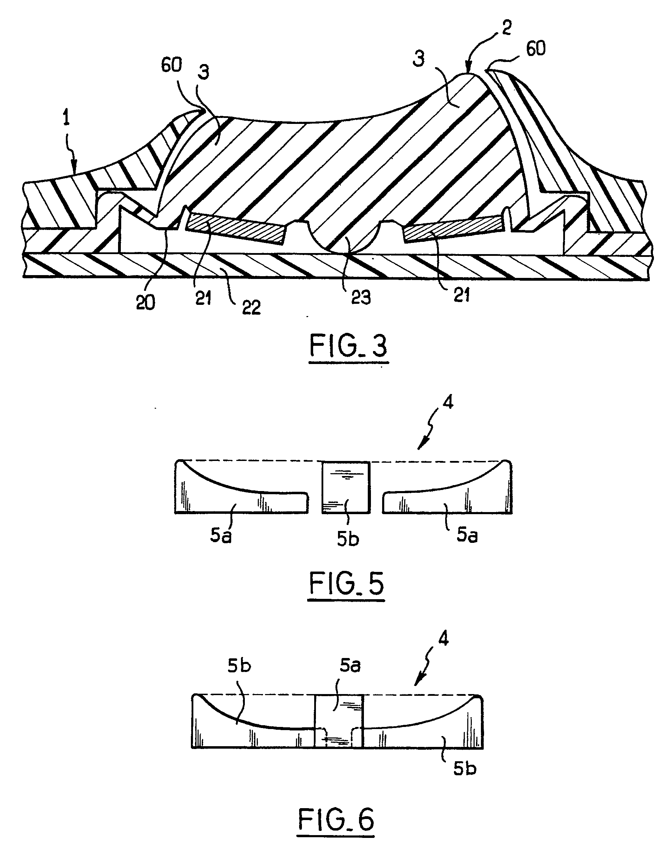

Par ailleurs ainsi que l'illustre partiellement la figure 2 et plus précisément la figure 3, les deux parties 3 des touches 2 destinées à être actionnées par des doigts autres que le pouce, présentent chacune un profil incurvé vers l'intérieur de la touche 2 correspondante et incliné vers le haut du centre de cette touche vers l'extérieur de chaque partie 3 suivant la direction de déplacement des doigts et en ce qu'une action sur chacune de ces parties 3 provoque une modification de l'état d'un contact électrique à laquelle est sensible le circuit électronique 10.

Par exemple (fig 3), la face intérieure 20 de chaque partie 3 d'une touche 2 peut supporter un organe en matériau conducteur de l'électricité 21 qui, lorsque la partie correspondante est enfoncée sous l'action d'un doigt, est appliqué contre un circuit imprimé 22 reliant la touche 2 au circuit électronique 10 de sorte que l'état d'un contact électrique porté par le circuit imprimé 22 en regard de ladite face intérieure 20 soit modifié, cette modification étant par ailleurs prise en compte par le circuit électronique 10 pour interpréter l'état de la touche 2 correspondante. De manière avantageuse, on remarquera que le profil de chaque partie 3 est conçu de manière à être tactilement perceptible.

De même, ainsi que l'illustrent partiellement les figures 5 et 6, les quatres parties 5a, 5b de la touche 4 destinée à être actionnée par le pouce, présentent chacune un profil incurvé vers l'intérieur de la touche 4 et incliné vers le haut du centre de cette touche vers l'extérieur de chaque partie 5a, 5b suivant les directions préférentielles de déplacement du pouce, et en ce qu'une action sur chacune des ces parties provoque une modification de l'état d'un contact électrique à laquelle est sensible le circuit électronique 10.

On entend par directions préférentielles de déplacement du pouce celles qui, ainsi que l'illustre la figure 4, lorsque la main est posée sur une surface plane, sont le plus aisément exécutables, c'est-à-dire comme indiqué plus haut, les déplacements d'avant vers l'arrière et vice-versa et de l'intérieur vers l'extérieur et vice-versa de la main.

En ce qui concerne la modification de l'état d'un contanct électrique engendrée par une action sur chacune des parties de la touche 4 destinée au pouce, on retiendra de préférence une structure identique à celle des touches 2 actionnées par les doigts autres que le pouce.

La forme de réalisation particulière décrite à la figure 3 pour une touche 2 destinée aux doigts autres que le pouce peut ainsi s'appliquer à la paire de parties 5b qui sont adjacentes. On notera sur la figure 3 le pivot central 23 de part et d'autre duquel pivote la touche 2 lorsque l'une de ses parties 3 est actionnée et qui permet d'éviter tout actionnement simultané des deux parties 3 de cette touche et par conséquent, toute modification simultanée de l'état des contacts électriques associés à cette touche. Pour la touche 4 destinée au pouce, on évite ainsi de même l'actionnement simultané des parties 5b tandis que pour les parties 5a, cet actionnement simultané est interdit par la séparation physique procurée par les parties 5a. Par ailleurs, on comprend que les cornes 60 du clavier 1 (fig. 3) adjacentes aux extrémités extérieures de chaque partie 3 complètent la perception tactile procurée par le profil de ces parties.

Pour des touches sensibles, l'actionnement simultané des parties de chaque touche peut être interdit par un traitement électronique connu en soi. Ce traitement électronique permet de mesurer et de comparer les pourcentages de surface recouverte par un doigt. La partie activée est alors celle dont le pourcentage de surface recouverte est le plus élevé au moment considéré. Dans tous les cas (touches sensibles et électromécaniques), un traitement logique fait que seule la partie qui a été actionnée la première est considérée comme activée. Une autre partie ne pourra être considérée comme activée que si toutes sont préalablement passées par un état non activé. Pour des touches sensibles, ce verrouillage logique peut être renforcé en créant une zone non sensible entre les parties de chaque touche de telle façon que, même en l'absence d'une remontée du doigt, la partie quittée par le doigt en train de glisser puisse être désactivée.

Ainsi, sur le clavier qui vient d'être décrit et dont les touches 2, 4 sont de préférence disposées sur une surface plane, n'importe quelle partie d'une de ces touches peut être actionnée par un doigt en même temps que l'une des autres touches par les autres doigts, sans déplacement sensible de la main. Un clavier à trois touches destinées aux doigts autres que le pouce et une touche destinée au pouce ayant la structure décrite plus haut, procure (3X3X3X5)-1 soit 134 actionnements et combinaisons d'actionnements de touches différents qui sont susceptibles de générer le même nombre de signes ou caractères alphanumériques ou analogues. La structure des touches, leur position relative et le nombre d'états distincts que chacune d'entre elles est susceptible de prendre permettent de réaliser le meilleur compromis relativement à la simplicité, la facilité et la fiabilité d'utilisation.

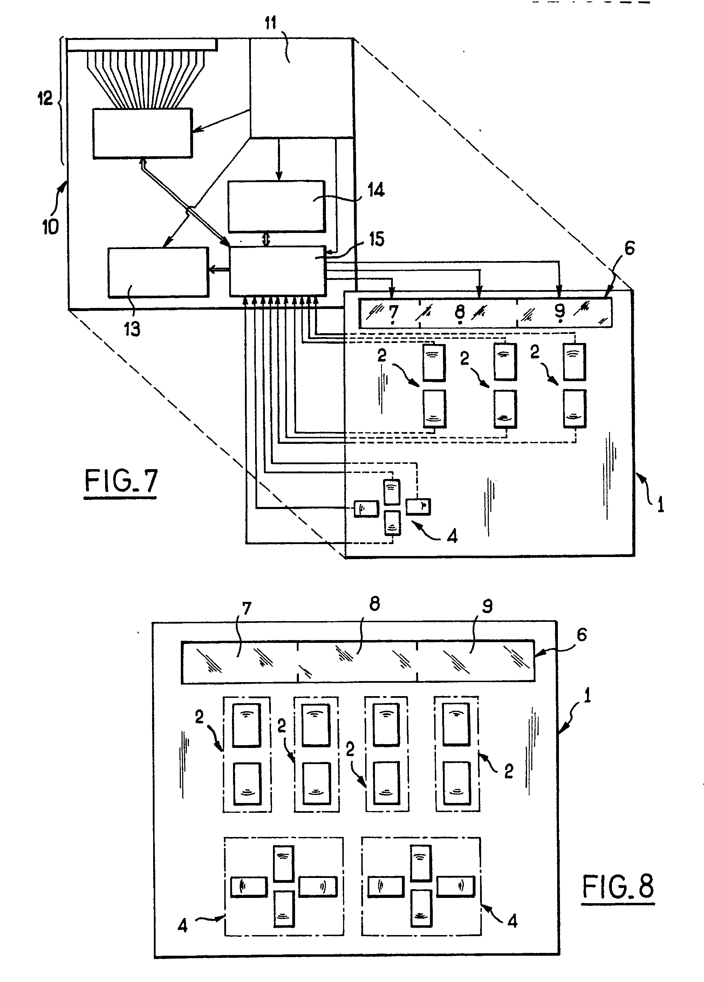

Ainsi que l'illustre la figure 7, le circuit électronique 10 comprend un microprocesseur 15 qui est relié électriquement d'une part aux touches 2, 4, aux moyens de visualisation 6 et aux moyens de raccordement extérieur 12 et d'autre part à des moyens formant mémoire 13, 14, ainsi que des moyens d'alimentation 11 reliés au microprocesseur 15 et aux moyens formant mémoire 13, 14 de sorte que le présent clavier 1 est autonome.

Les moyens formant mémoire 13, 14, comprennent de préférence une mémoire vive ou à accès aléatoire dite mémoire RAM 13 et une mémoire ROM dite mémoire morte 14. par ailleurs, les moyens de visualisation 6 sont répartis en trois régions de visualisation distinctes 7, 8, 9. Suivant l'invention, le microprocesseur 15 est programmé pour réagir instantanément à l'actionnement d'une ou de plusieurs touches 2,4 ou plus précisément à la modification de l'état du contact électrique associé à la partie de ces touches qui a été actionnée pour délivrer, sous une forme codée appropriée, par exemple suivant le code ASCII, un signal indicatif de cet actionnement et adresser ce signal vers les moyens de visualisation 6 de sorte que soit affichée, par exemple dans la première région de visualisation 7, une donnée correspondant, suivant un code déterminé, à la touche actionnée ou à la combinaison de touches actionnées.

Le code prédéterminé précité est une table de transcodage stockée dans la mémoire ROM 14 et dont une forme basique spécifique à l'invention sera détaillée plus loin.

Ainsi l'utilisateur est informé à tout moment c'est-à-dire en temps réel, de la signification des opérations qu'il exécute sur le clavier puisqu'à chaque fois que l'état d'une touche est modifié, le contenu de la première région de visualisation 7 est modifié en conséquence.

A ce stade, le signal indicatif de l'actionnement effectué n'est encore que généré et il ne sera adressé vers les moyens de raccordement extérieur 12 pour envoi immédiat vers le dispositif à commander relié au clavier ou, optionnellement vers la mémoire RAM 13 pour un stockage temporaire, qu'après validation.

Suivant l'invention cette validation est réalisée par la remontée des doigts autres que le pouce, c'est-à-dire le relachement de toutes les touches correspondantes.

Plus précisément, le microprocesseur 15 est programmé pour n'adresser vers les moyens de raccordement extérieur 12 ou la mémoire RAM 13 d'une part et vers les moyens de visualisation 6 d'autre part, un signal indicatif de la donnée affichée dans la première région de visualisation 7, que lorsque toutes les touches 2 affectées aux doigts autres que le pouce ont été relachées, le signal adressé à l'instant correspondant étant celui indicatif de la donnée visualisée dans la première région de visualisation 7 un temps prédéterminé "n" avant cet instant, la donnée correspondant à ce signal étant affichée dans la deuxième région de visualisation 8 des moyens de visualisation 6 tandis que la première région de visualisation 7 est mise à blanc en attente de la génération d'un nouveau signal. La valeur "n" est paramétrable pour s'ajuster au niveau de dextérité de l'opérateur. Cette valeur peut par exemple varier entre deux dixièmes de seconde et cinq secondes. Ainsi l'utilisateur pourra rechercher par tatonnement la combinaison qui donne le signal souhaité, corriger la combinaison de positions de ses doigts avant que le signal soit validé alors que sur les claviers classiques cette correction n'est possible que pour les caractères car les commandes sont en général exécutées immédiatement et nécessite de toute façon un retour en arrière puis l'exécution de la bonne combinaison, et enfin tirer parti de la progression de sa dextérité sans être pénalisé par des modalités de fonctionnement qui auraient été prévues pour que le débutant puisse réussir à utiliser le clavier, ou à l'opposé, qui obligeraient le débutant à corriger sans cesse ou à rechercher sur des guides divers toujours encombrants.

Par opposition au rôle des doigts, le rôle du pouce est différent. Selon l'invention, la remontée du pouce met la touche à cinq états dans un état non activé (état 5) mais ne joue aucun rôle dans la validation du signal. Le signal validé est simplement différent quand le pouce de l'opérateur active l'un des cinq états. Le pouce peut donc rester en position stable dans l'un des cinq états prévus. Ainsi, chaque état de la touche 4 destinée au pouce, lorsqu'il est activé, permet l'accès à cinq ensembles de caractères, signes ou instructions d'une manière qui sera détaillée plus loin. Grace à la reconnaissance tactile de la position du pouce apportée par la forme de la touche, l'opérateur sait à tout moment à quel ensemble il a accès, pour l'action des autres doigts que le pouce, sans avoir à regarder un éventuel indicateur de statut. De plus on retrouve ici le mode de fonctionnement des touches classiques de conversion "majuscules" qui permet de générer un signe au même moment qu'on active une touche, mais ici quatre fois au lieu d'une seule, et sans avoir à disposer de deux touches à droite et à gauche et l'on évite l'inconvénient des touches de type "Ctrl" ou "Alt" qui, elles, ne sont qu'en un seul exemplaire et empechent ainsi l'opérateur travaillant des deux mains de conserver la spécialisation de chaque main. Cet avantage est d'autant plus sensible lorsque le message à préparer comprend des signes variés.

La mobilité du pouce est enfin utilisée pour générer des instructions importantes comme "Espace", "Enter", "Ctrl" et "Retour à l'état de base". Suivant l'invention, celles-ci sont générées et validées par l'action du pouce, la production du signal correspondant se faisant uniquement lorsque tous les autres doigts sont levés et que le pouce réalise une séquence descente-remontée sur l'une des quatres parties 5a, 5b de la touche affectée au pouce 4. Par exemple (fig 4), "Espace" s'obtient par une action sur la partie intérieure "INT", "Enter" par une action sur la partie arrière "ARR", "Ctrl" par une action sur la partie extérieure "EXT" et "retour à l'état de base" par une action sur la partie avant "AVT". Par contre, lorsque l'une quelconque des touches "doigts autre que le pouce" 2 est activée, il n'y a pas lorsque la touche pouce 4 change d'état, génération ni validation d'un signal mais simplement changement du signal généré directement en fonction du changement d'ensemble, résultant du déplacement du pouce.

La troisième région de visualisation 9 peut par exemple servir à visualiser, en temps réel, l état du clavier de manière codée ou en "clair".

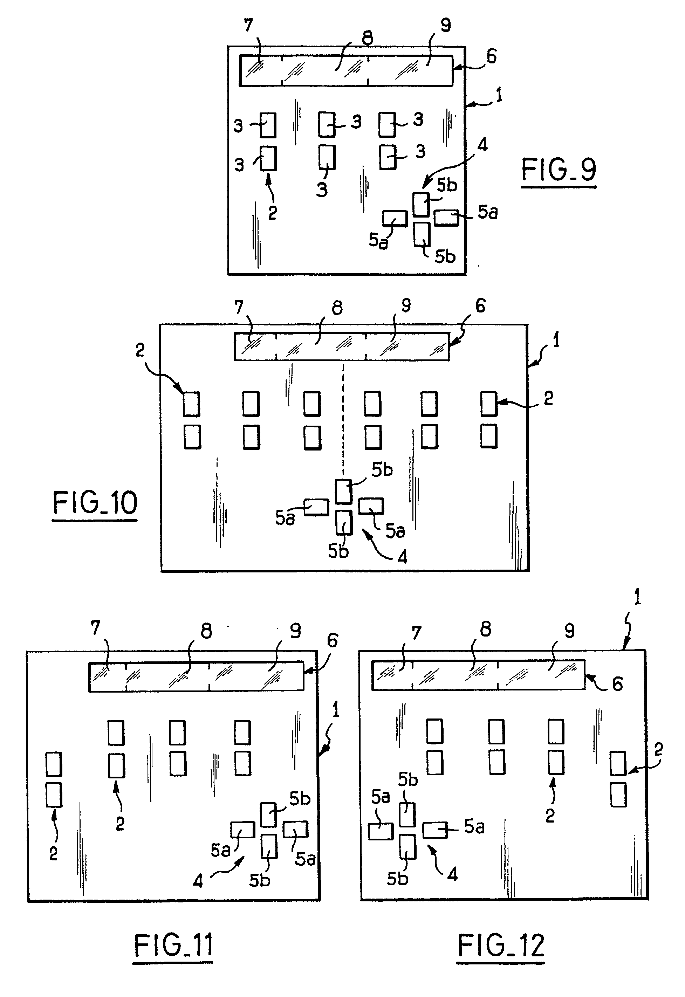

Le clavier décrit en référence aux fig. 1 à 7 n'occupe pas une surface supérieur à 6 x 8 cm$^2$, soit celle d'une carte de crédit. En outre, il peut aisément être adapté à divers types d'utilisation. La figure 9 illustre par exemple un clavier 1 utilisable de la main gauche par un utilisateur gaucher bien que pouvant convenir également à un droitier qui voudrait conserver la disponibilité de sa main droite plus habile.

Les figures 8 et 10 représentent un clavier 1 destiné à des postes de travail partagés par des utilisateurs variés. Sur le clavier de la fig. 10 seules les touches 2 destinées aux doigts autres que le pouce sont dédoublées et disposées symétriquement de part et d'autre de la touche pouce 4. Le micro-processeur reconnaît alors que l'usager travaille d'une main ou de l'autre par la nature des touches 2 "doigts autres que le pouce" qui sont activées. La signification de ces touches 2 est aussi transposée symétriquement car c'est la position d'une touche par rapport à la main qui l'utilise qui détermine son rôle. Ainsi les touches à l'extrême droite et l'extrême gauche du clavier sont toutes deux affectées à l'annulaire, respectivement de la main droite et de la main gauche. Par ailleurs, les parties "INT" et "EXT" de la touche pouce 4 échangent leurs rôles suivant que ce sont les touches "doigts" 2 de droite ou de gauche qui sont utilisées. Inversement, sur le clavier de la fig. 8, c'est la touche pouce 4 qui est déboublée tandis que la touche "doigt autre que pouce" 2 la plus à droite du clavier ne sera normalement pas utilisée par une main gauche et celle la plus à gauche ne sera normalement pas utilisée par une main droite. Dans ce cas l'utilisation du clavier par une main gauche ou droite peut être également reconnue par le microprocesseur (par programmation appropriée) suivant la touche pouce 4 utilisé. Le clavier de la figure 8 n'occupe en outre pas une superficie supérieure à 40 cm².

Les claviers des fig. 11 et 12 comportent quatre touches 2 à trois états, une pour l'index, une pour le majeur, une pour l'annulaire, et une pour l'auriculaire et une touche 4 à cinq états. Ce type de clavier mobilise tous les doigts d'une main et fournit directement 3X3X3X3X5 - 1 = 404 signes ou analogues différents. Cette forme de réalisation est la plus puissante et apporte un nombre de signes accessibles directement bien supérieur à ceux du code ASCII étendu qui n'en comporte que deux cent cinquante-six. Suivant les applications et les utilisateurs, on pourra soit n'utiliser qu'une partie des combinaisons afin de pouvoir appliquer sans trop de contrainte une table de correspondance mnémonique naturelle, soit utiliser les deux cent soixant-dix combinaisons supplémentaires disponibles directement (404-134 = 270) pour générer des signes plus élaborés comme des syllabes entières ou des signes spécifiques à une application dans un métier donné, soit batir un système entièrement syllabique pour des langues qui n'utiliseraient que 350 syllabes environ.

Les claviers des fig. 11 (main gauche) et 12 (main droite) seront avantageusement rendus compatibles avec ceux des figures précédentes, de telle façon que le passage de l'utilisation du clavier à quatre doigts à un clavier à cinq doigts se fasse avec le maintien intégral de l'acquit, les deux cent soixante-dix possibilités supplémentaires directes étant rendues accessibles par l'utilisation de la touche supplémentaire (auriculaire) sans changer les signes accessibles lorsque cette touche est non utilisée ou absente.

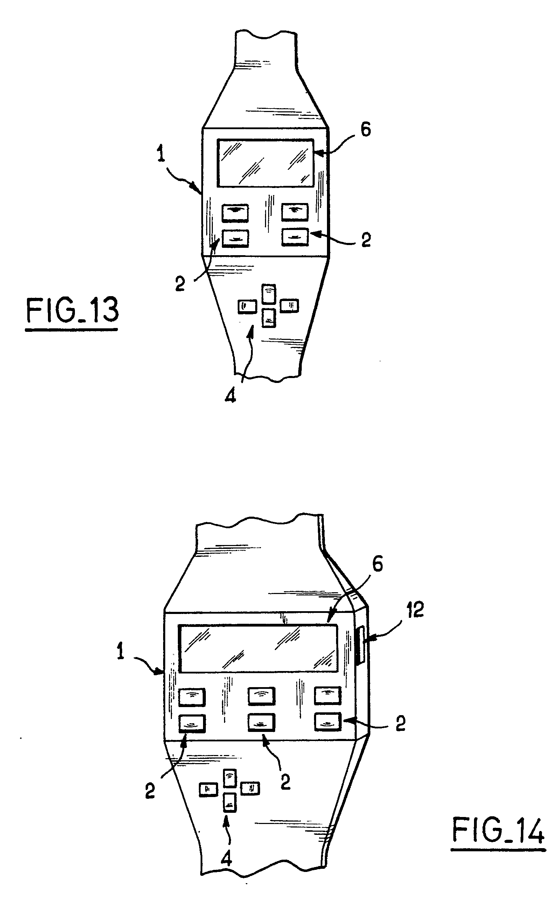

Le clavier de la figure 13 ne comporte que deux touches 2 à trois états et une touche 4 à cinq états qui permettent de générer directement (3X3X5 - 1) = 44 signes distincts. Cette réalisation est très avantageuse par sa compacité et le peu de surface nécessaire pour l'implanter et ne fait appel qu'aux doigts les plus habiles de la main. Elle convient bien à toutes les réalisations de type poignet (montres) ou carte de crédit (agendas, calculatrices) où la partie clavier se contente de 3X3 cm² tout en procurant directement tous les chiffres, lettres et codes opérations nécessaires, sans compter tous les signes qui sont accessibles en déclenchant un changement de statut par une action analogue à celle des touches de conversion ou de type "Caps-Lock" ou "Nums-Lock" sur les claviers classiques.

A ce stade de la description de l'invention, il est nécessaire de fournir une correspondance mnémonique entre les signes utilisés dans les messages écrits et telle ou telle combinaison de positions de doigts. Il est certes d'usage courant de rendre les claviers paramétrables en fonction des préférences de l'utilisateur. Par exemple, les claviers des microordinateurs peuvent, par simple appel d'un petit programme, passer de la norme QWERTY à la norme AZERTY, quoique sans pouvoir changer les signes gravés sur les touches. Pour ces claviers paramétrables, on distingue entre le signal élémentaire généré par l'enfoncement d'une touche et l'interprétation qu'en fait l'ordinateur. Le passage entre le signal généré et celui qui sera pris en compte pour les besoins de l'utilisateur, se fait par des tables de transcodage. Ces tables de transcodage sont très faciles à définir et très souples d'utilisation. L'invention utilise ce procédé pour faire le lien entre les différentes combinaisons de positions des doigts et les signes alphanumériques ou graphiques correspondant aux besoins de l'utilisateur. Le codage proprement informatique de ces signes alphanumériques ou graphiques est celui nécessaire au dispositif auquel les claviers, quel que soit leur type, sont reliés (code ASCII, code EBCDIC...), ce codage informatique étant choisi soit à la construction du clavier, soit lors du paramétrage des conditions de communication entre le clavier et le dispositif à commander.

Les claviers selon l'invention permettent d'utiliser au maximum ce potentiel de souplesse. En effet les touches n'étant pas revêtues d'inscriptions, il n'y a aucune gêne pour l'utilisateur à utiliser sa propre table de transcodage, indépendamment de celles utilisées par les autres utilisateurs successifs de ce même clavier. Cette faculté d'adapter un clavier unique à toute une variété d'utilisations et d'utilisateurs est facilitée par le fait que l'on distingue la génération/visualisation du signe et la validation de ce signe, ce distingo étant impossible avec les claviers classiques qui créent un signal dès que l'on actionne une touche et le répètent tant que la touche est actionnée. Selon l'invention , chaque utilisateur retrouve, sur une visualisation intermédiaire, la signification de chaque combinaison de positions de doigts, sans être géné par des inscriptions sur les touches. Les inscriptions sont superflues alors que dans les claviers classiques, elles sont indispensables.

Bien qu'il soit probable que, lorsque ce type de clavier sera répandu, il existera plusieurs variantes de tables de correspondance entre les positions des doigts et les signes générés, il est néanmoins nécessaire, pour que le clavier puisse servir à tout le monde, que tout le monde partage un certain nombre de codes communs tels que tout utilisateur puisse quelque soit l'état ou a été laissé le clavier par l'utilisateur précédent, commander au clavier de se mettre dans l'état ou il souhaite l'utiliser.

Ainsi, un clavier conforme à l'invention comprend en mémoire ROM 14 une table basique de transcodage qui permet au microprocesseur d'adresser un signal codé indicatif de l'actionnement d'une partie de touche ou d'une combinaison de parties de touches vers les moyens de visualisation et/ou tout dispositif de commande d'entrée par clavier relié à ce clavier pour produire les signes utilisés pour les messages et les instructions émis avec les langues occidentales (c'est-à-dire utilisant une variante de l'alphabet latin), soit au moins l'ensemble des signes alphanumériques et analogues du code ASCII.

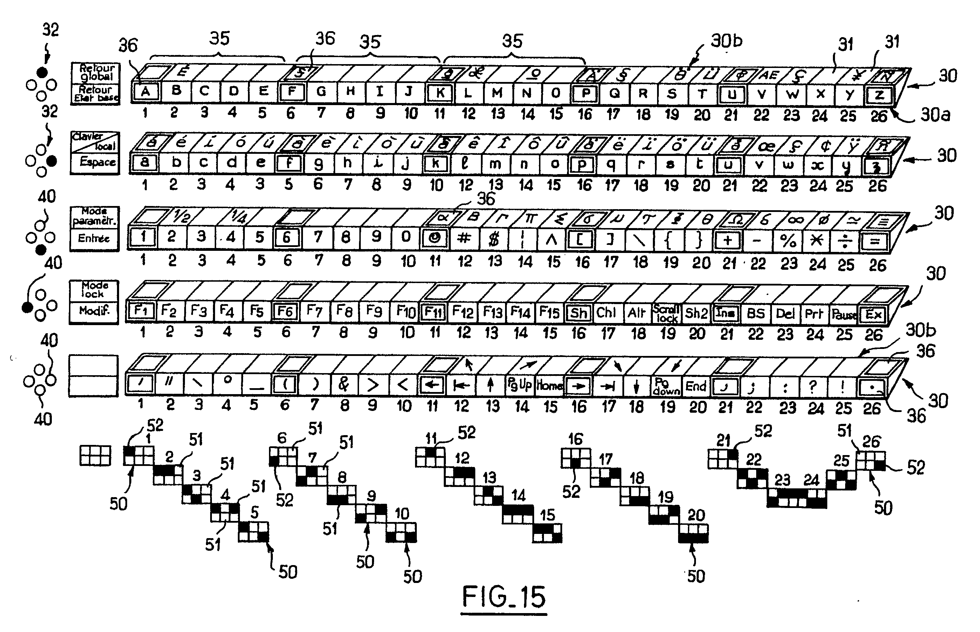

Cette table basique de transcodage est spécifique à l'invention et même si, comme on le verra plus loin, on peut programmer le microprocesseur du clavier pour que ce dernier soit paramétrable suivant une table de transcodage différente de la table basique, il sera toujours possible de prévoir une commande du clavier permettant de revenir à la table basique. On va maintenant décrire les caractéristiques essentielles de celle-ci en référence à la figure 15, lorsqu'elle est associée à un clavier tel que celui décrit en référence aux fig. 1 à 7.

Ainsi, la table comprend cinq paires 30 de séries 30a, 30b de vingt six cases 31, chaque paire 30 étant associée à un groupe 32 de quatre cercles 40. Les cercles 40 représentent les quatre parties de la touche à cinq états destinée au pouce. Lorsqu un des cercles 40 est noirci cela signifie que la partie correspondante de cette touche est actionnée. Un des cinq groupes 32 de cercles 40 n'en comporte aucun de noirci parce qu'il correspond à l'état dans lequel aucune des parties n'est actionnée. Les 26 cases de chaque série 30a, 30b correspondent à chacune des vingt-six combinaisons de positions des doigts autres que le pouce (3X3X3-1 = 26). Chacune des vingt-six combinaisons est symbolisée par un rectangle 50 contenant six carrés 51· disposés comme les six parties actionnables de ces trois touches destinées aux doigts autres que le pouce. Lorsqu'un carré 51 est noirci, cela signifie que la partie correspondante est actionnée. Chaque case 31 d'une série 30 de 26 cases contient un signe ou la représentation conventionnelle d'une commande ASCII. Les cinq séries principales 30a correspondent aux signaux obtenus directement d'une part grace à l'action du pouce sur la touche à cinq états et d'autre part grace à l'action des autres doigts sur les touches à trois états. Les cinq autres séries 30b correspondent aux signaux obtenus après une action correspondant à une séquence descente-remontée du pouce sur la partie extérieure "EXT" de la touche à cinq états.

Le principe mnémonique retenu est celui de la séquence logique. Les séquences utilisées sont connues par les utilisateurs potentiels et ne représentent pas un apprentissage significatif; par exemple les vingt-six lettres de l'alphabet sont rangées dans l'ordre alphabétique A, B, C, D, E... Comme il serait fastidieux de chercher le numéro d'ordre d'un signe dans une séquence de vingt-six, les séries 30a, 30b sont découpées en cinq sousséries 35 de cinq signes et une sous-série d'un signe, commençant par un signe repère. Par exemple les lettres A, F, K, P, U, Z sont les signes repères de l'alphabet. Les signes repères affectés de façon uniforme aux combinaisons 1, 6, 11,16, 21, 26 de positions des doigts sont représentés dans des cases à double encadré 36 et correspondent aux six combinaisons 52 les plus simples puisque ne faisant appel qu'à l'action d'un seul doigt. Avec trois touches à trois états, il y a bien six combinaisons de ce type. Les autres signes de chaque sous-série 35 de cinq signes s'obtiennent par des combinaisons de positions des doigts qui découlent logiquement (par exemple par permutation circulaire) de l'utilisation des autres doigts en plus de celui qui produit le signe repère 36. Les quatre rectangles 50 correspondant à chacune de ces combinaisons sont représentés en dessous de celui 52 de la combinaison repère et dans l'alignement des dix cases, parmi les 26X10 qui correspondent, pour les doigts autres que le pouce, à la combinaison symbolisée. Pour faciliter le repérage, le numéro de la combinaison correspondante est indiqué au-dessus de chaque rectangle 50 de six carrés 51.

Par exemple, la combinaison 1 donne du haut vers le bas, les signes suivants : pouce en avant : A; pouce en position intérieure :a; pouce en arrière : 1; pouce en position extérieure : F1; pouce levé : apostrophe. Si on a fait"Ctrl" avant, on obtient dans le même ordre: valeur libre; à; valeur libre ; valeur libre; valeur libre. Et ainsi de suite pour les vingt-cinq autres combinaisons.

On peut donc obtenir ainsi tous les signes du code ASCII et une partie de ceux du code ASCII étendu. De plus, un grand nombre des 130 combinaisons accessibles via l'action"Ctrl" (action descente-remontée du pouce sur la partie extérieure de la touche à cinq états) sont disponibles pour un usage spécifique.

C'est une caractéristique importante des claviers réalisés selon l'invention d'être paramétrables afin de s'adapter aux besoins et préférences de tels ou tels utilisateurs. Ce paramétrage peut bien évidemment être conservé dans la mémoire du dispositif qu'il s'agit de commander, comme cela se fait sur les microordinateurs pour passer du standard Qwerty américain à un autre standard ou pour travailler avec un logiciel particulier.

Suivant l'invention, le paramétrage est disponible aussi au sein du clavier selon un mode interactif qui va être décrit ci-après.

"Ctrl" + "Enter" fait d'abord passer en mode paramétrage et apparaître un menu sur les moyens de visualisation du clavier offrant le choix entre le paramétrage du mode de communication, celui du clavier et cellui de la temporisation (réglage de "n").

Lorsqu'on choisit le paramétrage du clavier, on se voit proposer les paramétrages (tables de transcodage) déjà mémorisés et conservés sous un nom spécifique. On peut alors choisir un paramétrage existant ou demander la création d'un nouveau paramétrage en exécutant "End" + "Ins", puis il faut donner le nom spécifique du nouveau paramétrage, le clavier demande le nom du paramétrage des combinaisons de positions des doigts pris comme base de départ et enfin le nom du code (par exemple le code ASCII étendu) avec lequel on va travailler. Ceci fait, le clavier est en mode paramétrage. Dans ce mode paramétrage, l'accès aux combinaisons possibles pour les positions des touches s'obtient en actionnant chacune de ces combinaisons. L'indication du ou des signes qui devront, lorsque l'on utilisera le paramétrage en cours de création, être générés par cette combinaison est réalisable de deux façons :

Soit en codant chacune des combinaisons du paramétrage de base (figure 15) qui génèrent les signes de la séquence que l'on veut mémoriser, en les séparant par des "Ins",

soit en déclarant par "Alt" + la position de chaque signe dans le code (ASCII par exemple) + "Ins" chacun des signes de la séquence que l'on veut mémoriser.

La fin de la séquence se déclare par "Enter".

La fin du paramétrage s'obtient en faisant "Ctrl" + "Enter". Le clavier demande alors si l'on veut revenir au paramétrage existant ou valider celui qu'on vient de créer.

Bien entendu, le nombre de paramétrages possibles sera limité par la capacité mémoire disponible dans le clavier utilisé et le nombre de caractères mémorisés dans une séquence sera limité au nombre de positions de la première région de visualisation du clavier.

La table de la figure 15 représente une sorte de clavier. L'utilisateur débutant peut donc l'utiliser comme un guide. Mais à la différence de la recherche sur un clavier classique l'utilisateur ne regarde pas les touches et c'est son système nerveux qui transcode de la représentation symbolique au positionnement des doigts. Ce mode de fonctionnement est tout à fait similaire à celui de l'acquisition d'un réflexe et contrairement au travail spontané sur un clavier classique, l'utilisateur bénéficie d'un véritable entraînement à travailler en dissociant la pensée de l'action des doigts.

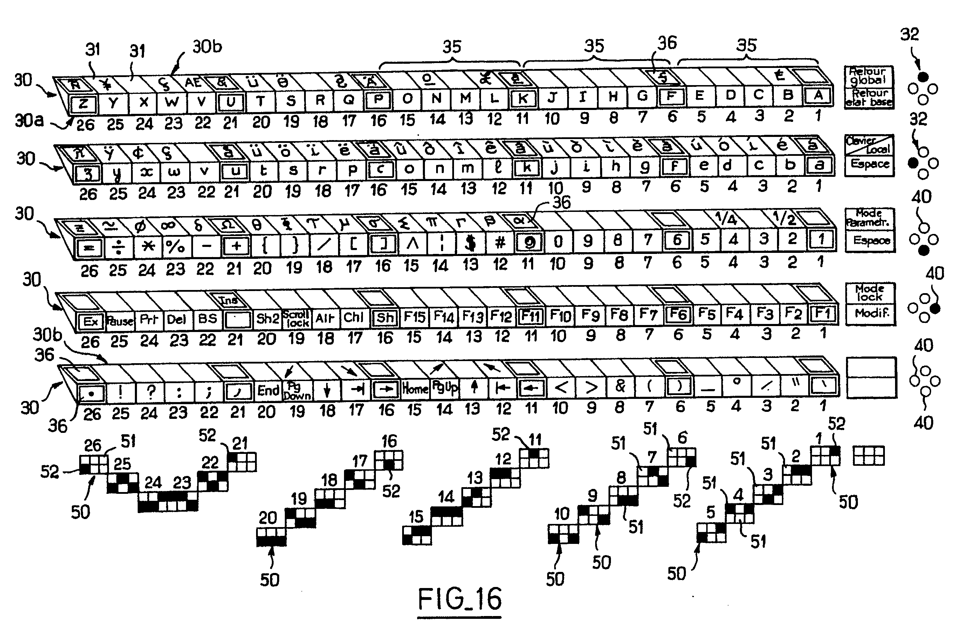

Cette dissociation se constate d'ailleurs lorsqu'un utilisateur passe d'un clavier main droite à un clavier main gauche ou vice et versa. Mentalement, l'utilisateur pense par exemple "index gauche" là où il y avait "index droit" et non pas doigt le plus à droite ou doigt le plus à gauche. C'est pour cette raison que les claviers droite et gauche selon l'invention sont réalisés symétriquement et qu'à la table de la figure 15 qui correspond à un usage main droit correspond une table symétrique illustrée fig. 16 qui correspond à un usage main gauche. Toutefois, on comprendra qu'il ne s'agit que d'une représentation symbolique et que la table de transcodage d'un clavier main gauche est identique à celle d'un clavier main droite.

Par ailleurs, le faible encombrement des claviers suivant l'invention les destine à être aussi utilisés comme des appareils portables autonomes personnels. Suivant l'invention, on a également prévu un travail en mode local et des possibilités de branchement et de communication avec tous les dispositifs classiques à commande par clavier. Ainsi, les moyens de raccordement 12 comprennent une broche de connexion polyvalente sur laquelle il est possible de brancher un certain nombre de cables de liaison vers l'entrée du clavier du dispositif à commander, l'entrée "RS232C" d'un microordinateur, d'une imprimante, d'un dispositif de stockage magnétique ou une prise téléphonique pour réaliser une communication à distance.

Afin de limiter les branchements et débranchements mécaniques une partie de la liaison sera avantageusement réalisée selon des techniques connues en soi, par infrarouge ou dispositif de couplage analogue sans contact vers un dispositif récepteur branché en permanence sur l'un quelconque des outils ci-dessus. De façon connue en soi, les différents modes de communication sont selectionnables et paramétrables de façon analogue à celui du paramétrage du clavier.

Ainsi la présente invention propose aussi bien des claviers actionnables d'une seule main et sans avoir à les regarder que des dispositifs personnels portatifs peu encombrants, comme celui de la figure 14 et en mesure de tirer parti de la miniaturisation croissante de tous les dispositifs électroniques (processeurs, mémoires, visualisations...),ces claviers et dispositifs portatifs étant d'un apprentissage aisé et n'isolant pas ceux qui les choisissent pour toutes les opérations de saisie, écriture et commandes sous forme électronique.

De plus, grâce à la table basique, la forme tactilement sensible des touches, la validation lorsque tous les doigts autres que le pouce sont remontés, la visualisation instantanée du signal correspondant à toute combinaison de positions actionnées, on obtient un clavier très facilement mémorisable car utilisant moins de 7 à 9 principes simples selon les conseils des experts.

- par le pouce, on choisit une série homogène (majuscules, minuscules, chiffres...),
- par le choix de l'une des six parties des trois touches, on choisit une sous-série,
- par la déclinaison séquentielle de la sous-série, on retrouve le signe mentalement désiré,
- par la sensation tactile ressentie par les bouts des doigts, on est prévenu de la correspondance effective avec ce que l'on a appris,
- par examen de la première région de visualisation,on peut chercher autour de la position incorrecte, en s'aidant d'une table visuellement structurée,
- on mémorise la sensation tactile en correspondance avec le signe cherché en les abandonnant simultanément mentalement et physiquement.

Ainsi, un débutant peut se servir efficacement du clavier au bout de quelques minutes et une personnes entraînée peut pratiquer de façon réflexe sans regarder ni table ni clavier pour les signes fréquents et retrouve rapidement les signes peu fréquents, probablement plus vite que sur un clavier classique où les lettres, signes et fonctions sont repartis de façon arbitraire et souvent différente d'un dispositif à un autre.

La présente invention n'est pas limitée aux exemples décrits et illustrés et on peut aporter à ceux-ci de nombreuses modifications.

**Revendications**

1. Clavier électronique actionnable d'une seule main, notamment pour générer des caractères alphanumériques et analogues et/ou des instructions de traitement, ce clavier comprenant plusieurs touches (2, 4) et un circuit électronique (10) relié électriquement à ces touches pour interpréter l'état des touches (2, 4) et délivrer un signal indicatif de celui-ci, ce circuit électronique (10) étant également relié à des moyens de visualisation (6) ainsi qu'à des moyens de raccordement extérieur (12), le clavier comprenant au moins deux touches (2) affectées aux doigts d'une main autres que le pouce et une touche (4) affectée au pouce, chaque touche (2) affectée à un doigt de la main autre que le pouce pouvant prendre trois états distincts sous l'action dudit doigt et comprenant deux parties (3) s'étendant suivant le prolongement de ce doigt, de sorte que chacune des deux parties (3) puisse être actionnée par le doigt correspondant en même temps que d'autres parties (3) de touches voisines par d'autres doigts, sans déplacement sensible de la main, la touche (4) affectée au pouce pouvant prendre cinq états distincts sous l'action du pouce, cette touche (4) comprenant quatre parties (5a, 5b) qui sont disposées de manière à pouvoir être actionnées sélectivement par le pouce, sans déplacement sensible de la main et en même temps qu'une partie (3) de chaque touche (2) affectée aux doigts autres que le pouce, caractérisé en ce que des moyens (23) sont prévus pour éviter tout actionnement simultané des différentes parties d'une même touche et/ou toute modification simultanée de l'état des contacts électriques associés à cette touche, et en ce que le circuit électronique (10) est adapté à ne prendre en compte, pour chaque touche, lorsque toutes les parties de cette touche sont relâchées, que la modification de l'état d'un contact qui est intervenue la première.

2. Clavier conforme à la revendication 1, caractérisé en ce que les deux parties (3) de chaque touche (2) destinée à être actionnée par un doigt autre que le pouce, sont suffisamment proches l'une de l'autre pour pouvoir être actionnées successivement par un mouvement d'avant vers l'arrière et vice-versa de l'extrémité du doigt.

3. Clavier conforme à l'une des revendications 1 ou 2, caractérisé en ce que les quatre parties (5a, 5b) de la touche destinée à être actionnée par le pouce comprennent une première paire (5a) disposée symétriquement de part et d'autre d'un axe (X-X') sur lequel est disposée l'autre paire (5b), ces parties étant suffisamment proches l'une de l'autre pour pouvoir être actionnées successivement par un mouvement d'avant vers l'arrière et vice-versa de l'extrémité du pouce pour l'une des paires (5b) et par un mouvement de l'intérieur vers l'extérieur de la main et vice-versa de l'extrémité du pouce pour l'autre paire (5a).

4. Clavier conforme à l'une des revendications 1 à 3, caractérisé en ce que les deux parties (3) des touches (2) destinées à être actionnées par des doigts autres que le pouce, présentent chacune un profil incurvé vers l'intérieur de la touche (2) correspondante, incliné vers le haut du centre de cette touche vers l'extérieur de chaque partie suivant la direction de déplacement des doigts et tactilement perceptible, et en ce qu'une action sur chacune de ces parties (3) provoque une modification de l'état d'un contact électrique à laquelle est sensible ledit circuit électronique (10).

5. Clavier conforme à l'une des revendications 1 à 4, caractérisé en ce que les quatre parties (5a, 5b) de la touche (4) destinée à être actionnée par le pouce, présentent chacune un profil incurvé vers l'intérieur de la touche (4), incliné vers le haut du centre de cette touche vers l'extérieur de chaque partie suivant les directions préférentielles de déplacement du pouce et tactilement perceptible, et en ce qu'une action sur chacune de ces parties (5a, 5b) provoque une modification de l'état d'un contact électrique à laquelle est sensible ledit circuit électronique (10).

6. Clavier conforme à l'une des revendications 1 à 5, caractérisé en ce que les touches (2, 4) sont disposées sur une surface plane (1) d'une manière telle que n'importe quelle partie d'une touche puisse être actionnée par un doigt en même temps que l'une des parties des autres touches par les autres doigts sans déplacement sensible de la main.

7. Clavier conforme à l'une des revendications 1 à 6, caractérisé en ce que le circuit électronique (10) comprend un microprocesseur (15) qui est relié électriquement d'une part aux touches (2, 4), aux moyens de visualisation (6) et aux moyens de raccordement extérieur (12) et d'autre part à des moyens formant mémoire (13, 14) ainsi que des moyens d'alimentation (11) reliés au microprocesseur (15) et aux moyens formant mémoire (13, 14).

8. Clavier conforme à la revendication 7, dans lequel les moyens de visualisation (6) comprennent au moins deux régions de visualisation (7, 8, 9), caractérisé en ce que le microprocesseur (15) est programmé pour réagir instantanément à l'actionnement d'une ou de plusieurs touches (2, 4) pour délivrer un signal indicatif de cet actionnement et adresser ce signal vers les moyens de visualisation (6) de sorte que soit affichée dans une première région de visualisation (7) une donnée correspondant, suivant un code déterminé, à la touche actionnée ou à la combinaison de touches actionnées.

9. Clavier conforme à la revendication 8, caractérisé en ce que le microprocesseur (15) est programmé pour n'adresser vers les moyens de raccordement extérieur (12) ou les moyens formant mémoire (13) d'une part et vers les moyens de visualisation (6) d'autre part, un signal indicatif de la donnée affichée dans la première région de visualisation (7), que lorsque toutes les touches (2) affectées aux doigts autres que le pouce ont été relâchées, le signal adressé à l'instant correspondant étant celui indicatif de la donnée visualisée dans la première région de visualisation (7) un temps prédéterminé (n) avant cet instant, la donnée correspondant à ce signal étant affichée dans une deuxième région de visualisation (8) des moyens de visualisation (6).

10. Clavier conforme à la revendication 9, caractérisé en ce que ledit temps prédéterminé (n) est réglable.

11. Clavier conforme à l'une des revendications 9 ou 10, caractérisé en ce que le microprocesseur (15) est programmé pour adresser des signaux préalablement stockés dans les moyens formant mémoire (13) vers les moyens de raccordement extérieur (12).

12. Clavier conforme à l'une des revendications 7 à 11, comprenant au moins trois touches (2) destinées à être actionnées par des doigts d'une même main autres que le pouce, caractérisé en ce qu'il comprend en mémoire (14) une table basique de transcodage qui permet au microprocesseur (15) d'adresser un signal codé indicatif de l'actionnement d'une partie (3, 5a, 5b) de touche ou d'une combinaison de parties de touches vers les moyens de visualisation (6) et/ou tout dispositif de commande d'entrée par clavier (1) relié à ce clavier pour produire au moins l'ensemble des signes alphanumériques et analogues du code ASCII par génération d'au moins cent trente quatre signaux codés différents.

13. Clavier conforme à la revendication 12, caractérisé en ce que la table basique de transcodage est disposée suivant cinq paires (30) de séries (30a, 30b) de vingt six signes ou instructions de traitement organisés de manière séquentielle, chaque paire (30) de séries (30a, 30b) étant accessible par une action sur l'une des parties (5a, 5b) de la touche (4) destinée au pouce.

14. Clavier conforme à la revendication 13, caractérisé en ce que chaque série (30a, 30b) de vingt-six signes est subdivisée en cinq sous-séries de cinq signes et une sous-série d'un signe, le premier signe (36) de chaque sous-série (35) étant accessible par une action sur l'une des parties (3) d'une seule touche (2) destinée à un doigt autre que le pouce, chacun des six premiers signes (36) étant accessibles par actionnement d'une partie (3) distincte.

15. Clavier conforme à la revendication 14, caractérisé en ce que les quatre autres signes (31) de chaque sous-série (35) de cinq signes sont disposés suivant une séquence logique universelle, telle que l'ordre alphabétique, ces quatre autres signes des quatre premières sous-séries étant accessibles suivant une combinaison d'actionnement de parties (3) des touches (2) destinées aux doigts autres que le pouce, obtenue logiquement par permutation circulaire, et comprenant au moins l'actionnement de la partie correspondant au premier signe (36) de la sous-série (35) correspondante, tandis que les deuxième et troisième signes d'une part et les quatrième et cinquième signes d'autre part de la cinquième sous-série de cinq signes sont accessibles de la même façon à partir respectivement de l'actionnement de la partie de touche autorisant l'accès au premier signe de cette cinquième sous-série et de celui autorisant l'accès au signe unique de la sixième sous-série.

16. Clavier conforme à l'une des revendications 13 à 15, caractérisé en ce que, seulement lorsque toutes les touches (3) destinées aux doigts autres que le pouce sont relâchées, une ou plusieurs actions fugitives sur l'une des parties (5a, 5b) de la touche (4) destinée au pouce permettent de générer des instructions de traitement particulières.

17. Clavier conforme à l'une des revendications 13 à 17, caractérisé en ce qu'il est alternativement paramétrable suivant une table de transcodage différente de la table basique.

18. Clavier conforme à l'une des revendications précédentes, caractérisé en ce qu'il comprend quatre touches (2) destinées aux doigts d'une main autres que le pouce et deux touches (4) destinées alternativement au pouce de cette main, ces touches (2, 4) étant disposées relativement les unes aux autres et reliées au circuit électronique (10) de sorte que le clavier (1) soit alternativement actionnable par la main gauche ou la main droite, et en ce que la superficie de ce clavier est inférieure ou égale à 40 cm².

19. Application d'un clavier (1) conforme à l'une des revendications précédentes à la réalisation d'un microcalculateur ou micro-ordinateur portatif.

## Claims

1. An electronic keyboard for one-hand operation more particularly for generating alphanumeric and analog characters and/or processing instructions, the keyboard comprising a plurality of keys (2, 4) and an electronic circuit (10) electrically connected to said keys to interpret the state of the keys (2, 4) and deliver a signal indicative thereof, said electronic circuit (10) also being connected to display means (6) and external connection means (12), said keyboard comprising at least two keys (2) associated with the fingers of the hand other than the thumb and one key (4) associated with the thumb, each key (2) associated with a finger of the hand other than the thumb being capable of assuming three different states in response to said finger and comprising two parts (3) extending in continuation of said finger, so that each of the two parts (3) can be actuated by the corresponding finger at the same time as other parts (3) of adjacent keys by other fingers, without appreciable movement of the hand, wherein the key (4) associated with the thumb can assume five different states in response to the thumb, said key (4) comprising four parts (5a, 5b) which are so disposed as to be actuated selectively by the thumb without appreciable movement of the hand and at the same time as a part (3) of each key (2) associated with the finger other than the thumb, characterized in that means (23) are provided to obviate any simultaneous actuation of the different parts of one and the same key and/or any simultaneous change of the state of the electrical contacts associated with said key, and the electronic circuit (10) is adapted to accept, for each key, when all the parts of said key are released, only the change of state of a contact which has occurred first.

2. A keyboard according to claim 1, characterised in that the two parts (3) of each key (2) adapted to be actuated by a finger other than the thumb are sufficiently close together to be actuated successively by a front-to-rear movement and vice-versa of the finger tip.

3. A keyboard according to claim 1 or 2, characterised in that the four parts (5a, 5b) of the key adapted to be actuated by the thumb comprise a first pair (5a) disposed symmetrically on either side of an axis (X-X') on which the other pair (5b) is disposed, said parts being sufficiently close together to be actuated successively by a front-to-back movement and vice-versa of the thumb tip for one of the pairs (5a) and by a movement from the inside to the outside of the hand and vice-versa of the thumb tip for the other pair (5a).

4. A keyboard according to any of claims 1 to 3, characterised in that the two parts (3) of the keys (2) adapted to be actuated by the fingers other than the thumb each have a profile which curves towards the interior of the corresponding key (2), inclined upwardly from the centre of said key towards the exterior of each part in the direction of movement of the fingers and perceptible to the touch, and an action on each of these parts (3) results in a change of the state of an electrical contact to which the said electronic circuit (10) is sensitive.

5. A keyboard according to any of claims 1 to 4, characterised in that the four parts (5a, 5b) of the key (4) adapted to be actuated by the thumb each have a profile which curves towards the interior of the key (4), inclined upwardly from the centre of said key towards the exterior of each part in the preferential directions of movement of the thumb and perceptible to the touch, and an action on each of these parts (5a, 5b) results in a modification of the state of an electrical contact to which the said electronic circuit (10) is sensitive.

6. A keyboard according to any of claims 1 to 5, characterised in that the keys (2, 4) are disposed on a flat surface (1) in such a manner that any part of a key can be actuated by a finger at the same time as one of the parts of the other keys by the other fingers without appreciable movement of the hand.

7. A keyboard according to any of claims 1 to 6, characterised in that the electronic circuit (10) comprises a microprocessor (15) which is electrically connected, on the one hand, to the keys (2, 4), to the display means (6) and to the external connection means (12) and, on the other hand, to memory means (13, 14) and supply means (11) connected to the microprocessor (15) and to the memory means (13, 14).

8. A keyboard according to claim 7, in which the display means (6) comprise at least two display zones (7, 8, 9), characterised in that the microprocessor (15) is programmed to react instantaneously to the actuation of one or more keys (2, 4) to deliver a signal indicative of said actuation and apply said signal to the display means (6) so that there is displayed in a first display zone (7) a data element corresponding, in accordance with a given code, to the actuated key or to the combination of actuated keys.

9. A keyboard according to claim 8, characterised in that the microprocessor (15) is programmed in such a manner that a signal indicative of the data element displayed in the first display zone (7) is fed to the external connection means (12) or the memory means (13), on the one hand, and to the display means (6), on the other hand, only when all the keys (2) associated with the fingers other than the thumb have been released, the signal delivered at the corresponding time being the signal indicative of the data element displayed in the first display zone (7) a predetermined time (n) before said corresponding time, the data element corresponding to said signal being displayed in a second display zone (8) of the display means (6).

10. A keyboard according to claim 9, characterized in that the said predetermined time (n) is adjustable.

11. A keyboard according to claim 9 or 10, characterised in that the microprocessor (15) is programmed to deliver signals previously stored in the memory means (13) to the external connection means (12).

12. A keyboard according to any claim 7 to 11, comprising at least three keys (2) adapted to be actuated by the fingers of one hand other than the thumb, characterised in that it comprises in a memory (14) a basic transcoding table which enables the microprocessor (15) to deliver a coded signal indicative of the actuation of a key part (3, 5a, 5b) or of a combination of key parts, to the display means (6) and/or any keyboard input control means connected to said keyboard (1) to produce at least all the alphanumeric and analog characters of the ASCII code by generation of at least one hundred and thirty-four different coded signals.

13. A keyboard according to claim 12, characterised in that the basic transcoding table is disposed in five pairs (30) of sets (30a, 30b) of twenty-six signs or processing instructions arranged sequentially, each pair (30) of sets (30a, 30b) being accessible by actuation of one of the parts (5a, 5b) of the thumb key (4).

14. A keyboard according to claim 13, characterised in that each set (30a, 30b) of twenty-six signs is subdivided into five sub-sets of five signs and one sub-set of one sign, the first sign (36) of each sub-set (35) being accessible by actuation of one of the parts (3) of a single key (2) intended for a finger other than the thumb, each of the first six signs (36) being accessible by actuation of a separate part (3).

15. A keyboard according to claim 14, characterised in that the other four signs (31) of each sub-set (35) of five signs are disposed in a universal logic sequence, such as alphabetical order, these other four signals of the first four sub-sets being accessible in accordance with a combination of actuation of parts (3) of the keys (2) intended for the fingers other than the thumb, obtained logically by circular permutation, and comprising at least actuation of the part corresponding to the first sign (36) of the corresponding sub-set (35), while the second and third signs,on the one hand, and the fourth and fifth signs, on the other hand, of the fifth sub-set of five signs are accessible in the same way respectively from actuation of the key part authorizing access to the first sign of said fifth sub-set and the key part authorizing access to the single sign of the sixth sub-set.

16. A keyboard according to any of claims 12 to 15, characterised in that specific processing instructions can be generated by one or more transient actions on one of the parts (5a, 5b) of the thumb (4) only when all the keys (3) for the fingers other than the thumb have been released.

17. A keyboard according to any of claims 12 to 16, characterised in that it is alternatively parametrable in accordance with a transcoding table different from the basic table.

18. A keyboard according to any of the preceding claims, characterised in that it comprises four keys (2) intended for the fingers of a hand other than the thumb and two keys (4) intended alternatively for the thumb of the same hand, said keys (2, 4) being disposed relatively to one another and connected to the electronic circuit (10) in such a manner that the keyboard (1) is alternatively adapted to actuation by the left hand or the right hand and in that the area of the keyboard is less than or equal to 40 cm$^2$.

19. Application of a keyboard (1) according to any of the preceding claims to the production of a portable micro-computer or micro-calculator.

**Patentansprüche**

1. Elektronische, mit einer Hand betätigbare Tastatur zur Erzeugung von alphanumerischen und analogen und/oder Befehlszeichen, mit mehreren Tasten (2, 4) und einer elektronischen Schaltung (10), die elektrisch mit den Tasten zur Auswertung des Zustands der Tasten (2, 4) und zur Bildung eines diesem Zustand entsprechenden Signals und ferner mit einer Anzeigeeinrichtung (6) sowie mit Schnittstellen (12) verbunden ist, wobei die Tastatur wenigstens zwei Tasten (2), die von den Fingern einer Hand, nicht jedoch von dem Daumen, betätigt werden, und eine vom Daumen betätigte Taste (4) aufweist, wobei jede nicht vom Daumen betätigte Taste (2) drei verschiedene Zustände unter der Einwirkung des betreffenden Fingers einnehmen kann und zwei sich in der Verlängerung des Fingers erstreckende Abschnitte (3) aufweist, so dass jeder der beiden Abschnitte (3) durch den zugehörigen Finger betätigt werden kann, während gleichzeitig andere Abschnitte (3) benachbarter Tasten durch andere Finger ohne wesentliche Verlagerung der Hand betätigbar sind, und wobei die vom Daumen betätigte Taste (4) fünf verschiedene Zustände unter Einwirkung des Daumens einnehmen kann, wobei diese Taste (4) vier Abschnitte (5a, 5b) aufweist, die so angeordnet sind, dass sie selektiv durch den Daumen ohne wesentliche Verlagerung der Hand und während der Betätigung eines Abschnitts (3) jeder nicht von dem Daumen betätigten Taste (2) betätigbar sind, dadurch gekennzeichnet, dass Mittel (23) zur Vermeidung jeder gleichzeitigen Betätigung verschiedener Abschnitte derselben Taste und/oder jeder gleichzeitigen Veränderung des Zustandes der dieser Taste zugeordneten elektrischen Kontakte vorgesehen sind und dass die elektronische Schaltung (10) so ausgebildet ist, dass sie für jede Taste nur die zuerst eingetretene Änderung des Zustandes eines Kontaktes auswertet, wenn die Abschnitte dieser Taste losgelassen werden.

2. Tastatur nach Anspruch 1, dadurch gekennzeichnet, dass die beiden Abschnitte (3) jeder zur Betätigung durch einen anderen Finger als den Daumen bestimmten Taste (2) ausreichend nah beieinander angeordnet sind, um nacheinander durch eine Bewegung der Fingerspitze von vorn nach hinten oder umgekehrt betätigt zu werden.

3. Tastatur nach Anspruch 1 oder 2, dadurch gekennzeichnet, dass die vier Abschnitte (5a, 5b) der zur Betätigung durch den Daumen bestimmten Taste (4) ein erstes Paar (5a) bilden, das symmetrisch beiderseits einer Achse (X-X') angeordnet ist, auf der das andere Paar (5b) liegt, wobei die Abschnitte ausreichend nahe beieinander angeordnet sind, um nacheinander durch eine Bewegung der Daumenkuppe von vorn nach hinten und umgekehrt für das eine Paar (5b) und von der Innenseite der Hand zur Aussenseite und umgekehrt für das andere Paar (5a) betätigt zu werden.

4. Tastatur nach einem der Ansprüche 1 bis 3, dadurch gekennzeichnet, dass die beiden Abschnitte (3) der nicht zur Betätigung durch den Daumen bestimmten Tasten (2) jeweils ein zur Innenseite der Taste (2) gekrümmtes Profil aufweisen, das vom Mittelpunkt der Taste (2) gegen die Aussenseite jedes Abschnitts in Bezug auf die Bewegungsrichtung des Fingers aufwärts geneigt und beim Tasten spürbar ist, und dass eine Betätigung einer der Abschnitte (3) eine Veränderung des Zustands eines elektrischen Kontakts hervorruft, auf die die elektronische Schaltung (10) reagiert.

5. Tastatur nach einem der Ansprüche 1 bis 4, dadurch gekennzeichnet, dass die vier Abschnitte (5a, 5b) der zur Betätigung durch den Daumen bestimmten Taste (4) jeder ein zur Innenseite der Taste (4) gekrümmtes Profil aufweisen, das vom Mittelpunkt der Taste (4) und gegen die Aussenseite jedes Abschnitts im Bezug auf die bevorzugten Bewegungsrichtungen des Daumens aufwärts geneigt und beim Tasten spürbar ist, und dass eine Betätigung jedes der Abschnitte (5a, 5b) eine Veränderung des Zustands eines elektrischen Kontakts hervorruft, auf die die elektronische Schaltung (10) reagiert.

6. Tastatur nach einem der Ansprüche 1 bis 5, dadurch gekennzeichnet, dass die Tasten (2, 4) auf einer ebenen Oberfläche (1) so angeordnet sind, dass gleich welcher Abschnitt einer Taste mit einem Finger gleichzeitig mit einem der Abschnitte anderer Tasten mit anderen Fingern ohne wesentliche Verlagerung der Hand gedrückt werden kann.

7. Tastatur nach einem der Ansprüche 1 bis 6, dasurch gekennzeichnet, dass die elektronische Schaltung (10) einen Mikroprozessor (15), der einerseits mit den Tasten (2, 4), der Anzeigeeinrichtung (6) und der Schnittstelle (12) und andererseits mit einem Speicher (13, 14) elektrisch verbunden ist, und eine mit dem Mikroprozessor (15) und dem Speicher (13, 14) verbundene Versorgungseinheit (11) aufweist.

8. Tastatur nach Anspruch 7 bei der die Anzeigeeinrichtung (6) wenigstens zwei Anzeigeabschnitte (7, 8, 9) aufweist, dadurch gekennzeichnet, dass der Mikroprozessor (15) so programmiert ist, dass er sofort auf die Betätigung einer oder mehrerer der Tasten (2, 4) reagiert und ein Anzeigesignal dieser Betätigung erzeugt und dieses Signal auf die Anzeigeeinrichtung (6) leitet, so dass bestimmte Ausgabedaten in einem ersten Anzeigeabschnitt (7) in einem bestimmten Code angezeigt werden, die der betätigten Taste oder der Kombination der betätigten Tasten entsprechen.

9. Tastatur nach Anspruch 8, dadurch gekennzeichnet, dass der Mikroprozessor (15) so programmiert ist, dass er auf die Schnittstelle (12) oder den Speicher (13) einerseits und auf die Anzeigeeinrichtung (6) andererseits ein den auf dem ersten Anzeigeabschnitt (7) angezeigten Daten entsprechendes Signal nur dann adressiert, wenn alle von den Fingern ausser dem Daumen betätigten Tasten (2) losgelassen worden sind, wobei das adressierte Signal zum betreffenden Zeitpunkt dasjenige ist, das auf dem ersten Anzeigeabschnitt (7) einen vorbestimmten Zeitraum (n) vor diesem Zeitpunkt dargestellten Daten entspricht und wobei die zu diesem Signal gehörenden Daten in einem zweiten Anzeigeabschnitt (8) der Anzeigeeinrichtung (6) angezeigt werden.

10. Tastatur nach Anspruch 9, dadurch gekennzeichnet, dass der vorbestimmte Zeitraum (n) einstellbar ist.

11. Tastatur nach Anspruch 9 oder 10, dadurch gekennzeichnet, dass der Mikroprozessor (15) so programmiert ist, dass er vorher im Speicher (13) abgespeicherte Signale auf die Schnittstelle (12) adressiert.

12. Tastatur nach einem der Ansprüche 7 bis 11, bestehend aus wenigstens drei Tasten (2), die zur Betätigung durch die Finger einer Hand mit Ausnahme des Daumens bestimmt sind, dadurch gekennzeichnet, dass sie in einem Speicher (14) eine Basis-Umcodier-Tabelle aufweist, durch die der Mikroprozessor ein codiertes Signal, das die Betätigung eines Abschnitts (3, 5a, 5b) einer Taste oder einer Kombination der Abschnitte der Tasten charakterisiert auf die Anzeigeeinrichtung (6) und/oder irgendeine mit diesem Klavier (1) verbundene Klaviereingangsbefehlseinrichtung adressiert, um wenigstens die Gesamtheit der alphanumerischen oder analogen Zeichen des Code ASCII durch Erzeugung von wenigstens einhundertvierunddreissig verschiedenen codierten Signalen zu erzeugen.

13. Tastatur nach Anspruch 12, dadurch gekennzeichnet, dass die Basis-Umcodierungs-Tabelle in fünf Paaren (30) von Reihen (30a, 30b) mit jeweils sechsundzwanzig, in sequentieller Weise organisierten Zeichen oder Bearbeitungsbefehlen angeordnet ist, wobei jedes Paar (30) der Reihen (30a, 30b) durch eine Betätigung eines der Abschnitte (5a, 5b) der zum Daumen gehörenden Taste (4) zugänglich ist.

14. Tastatur nach Anspruch 13, dadurch gekennzeichnet, dass jede Reihe (30a, 30b) der sechsundzwanzig Zeichen in fünf Unterreihen mit fünf Zeichen und eine Unterreihe mit einem Zeichen unterteilt ist, wobei das erste Zeichen (36) jeder Unterserie (35) durch Betätigung eines Abschnitts (3) einer einzigen, nicht dem Daumen zugeordneten Taste (2) zugänglich ist und jedes der sechs ersten Zeichen (36) durch Betätigung eines verschiedenen Abschnitts (3) zugänglich ist.

15. Tastatur nach Anspruch 14, dadurch gekennzeichnet, dass die vier anderen Zeichen (31) jeder Unterreihe (35) mit fünf Zeichen in einer universellen logischen Sequenz, wie die alphabetische Reihenfolge, angeordnet sind, wobei diese vier anderen Zeichen der vier ersten Unterserien durch eine Kombination der Betätigung von Abschnitten (3) der nicht dem Daumen zugeordneten Tasten (2) zugänglich sind, die sich logisch durch eine Ring-Permutation ergibt und wenigstens die Betätigung des zum ersten Zeichen (36) der jeweiligen Unterserie (35) gehörenden Abschnitts umfasst, während das zweite und das dritte Zeichen einerseits und das vierte und das fünfte Zeichen andererseits der fünfte Unterserie mit fünf Zeichen jeweils in derselben Weise ausgehend von der Betätigung des Tastenabschnitts, der den Zugang zum ersten Zeichen dieser fünften Unterserie ermöglicht bzw. des Tastenabschnitts, der den Zugang zum einzigen Zeichen der sechsten Unterserie ermöglicht, zugänglich sind.

16. Tastatur nach einem der Ansprüche 12 bis 15, dadurch gekennzeichnet, dass nur wenn alle nicht dem Daumen zugeordneten Tasten (2) losgelassen sind, eine oder mehrere vorübergehende Betätigungen eines der Abschnitte (5a, 5b) der dem Daumen zugeordneten Taste (4) die Erzeugung von besonderen Bearbeitungsbefehlen erlaubt.

17. Tastatur nach einem der Ansprüche 12 bis 16, dadurch gekennzeichnet, dass sie mit einer anderen als der Basis-Umcodierungs-Tabelle alternativ parametrisierbar ist.

18. Tastatur nach einem der vorstehenden Ansprüche, dadurch gekennzeichnet, dass sie vier den Fingern einer Hand mit Ausnahme des Daumens zugeordnete Tasten (2) und zwei Tasten (4) aufweist, die alternativ einem Daumen dieser Hand zugeordnert sind, wobei die Tasten (2, 4) relativ zueinander so angeordnet und mit der elektronischen Schaltung (10) so verbunden sind, dass die Tastatur alternativ mit der linken Hand oder mit der rechten Hand betätigbar ist und dass die Grösse der Oberfläche der Tastatur kleiner oder gleich 40 cm$^2$ ist.

19. Verwendung einer Tastatur (1) nach einem der vorstehenden Ansprüche zur Herstellung eines tragbaren Mikrocomputers oder Mikrorechners.

FIG_1

FIG_2

FIG_4

FIG. 3

FIG. 5

FIG. 6

FIG.7

FIG.8

FIG_9

FIG_10

FIG_11

FIG_12

FIG_13

FIG_14

FIG.15

EP 0 213 022 B1

FIG_16